(19) Europäisches Patentamt
European Patent Office
Office européen des brevets

(11) EP 1 881 742 A1

(12) **EUROPEAN PATENT APPLICATION**
published in accordance with Art. 153(4) EPC

(43) Date of publication:
**23.01.2008 Bulletin 2008/04**

(21) Application number: **06746097.2**

(22) Date of filing: **08.05.2006**

(51) Int Cl.:
***H05B 33/00*** *(2006.01)*

(86) International application number:
**PCT/JP2006/309266**

(87) International publication number:
**WO 2006/121015 (16.11.2006 Gazette 2006/46)**

(84) Designated Contracting States:
**DE FR GB**

(30) Priority: **11.05.2005 JP 2005138354**

(71) Applicant: **IDEMITSU KOSAN COMPANY LIMITED**
**Tokyo 100-0005 (JP)**

(72) Inventors:
- **TOMAI, Shigekazu**
  **2990293 (JP)**
- **KUMA, Hitoshi**
  **2990293 (JP)**
- **INOUE, Kazuyoshi**
  **2990293 (JP)**

(74) Representative: **Gille Hrabal Struck Neidlein Prop Roos**
**Patentanwälte**
**Brucknerstrasse 20**
**40593 Düsseldorf (DE)**

# (54) ORGANIC ELECTROLUMINESCENCE ELEMENT

(57) An organic electroluminescent device (1) including: a transparent electrode (12); a counter electrode (14) opposite to the transparent electrode (12); and one or more mutilayered structures between the transparent electrode (12) and the counter electrode (14), the structure including two organic emitting layers (20) and (22) and an intermediate conductive layer (30) between the organic emitting layers (20) and (22), the refractive index $n_a$ of the intermediate conductive layer (30) being different from the refractive index $n_b$ of at least one of the organic emitting layers by 0.25 or less, the intermediate conductive layer (30) containing an oxide containing one or more types of rare earth elements.

EP 1 881 742 A1

## Description

TECHNICAL FIELD

The invention relates to an organic electroluminescent device, and specifically to an organic electroluminescent device having a multilayered structure wherein two or more organic emitting layers are stacked with an intermediate conductive layer being interposed therebetween.

BACKGROUND

As one of technologies for prolonging lifetime and increasing efficiency of an organic electroluminescent device ("electroluminescent" is abbreviated to "EL" hereinafter), there is known the technology of stacking a plurality of cathode/organic emitting layer/anode units (Patent documents 1 to 3, for example). Such an organic EL device has a longer lifetime since a current density for obtaining the same luminance is lower than that of a single unit device.
However, the technology has the problem that wiring is complicated and an electrical power loss caused by the wiring resistance cannot be ignored since an extraction electrode must be formed to apply a voltage to an injection electrode (intermediate electrode) interposed between adjacent organic emitting layers.
To avoid the problem, for example, Patent documents 4 and 5 disclose that an electrode with a hole-injecting surface and the other electron-injecting surface is used as an intermediate electrode. The technology advantageously eliminates the need of an extraction electrode for the intermediate electrode.
However, the technology has the problem that the viewing angle dependency of the device is inferior; that is, the color of emitted light changes when the device is viewed from the front thereof and obliquely. The luminous efficiency of the device is also not sufficient.
For the problem, the applicant/assignee discloses in Patent document 6 a method for reducing the viewing angle dependency in emission wavelengths by selecting materials such that the difference in refractive index between an organic emitting layer and intermediate electrode is 0.2 or less.
However, a long lifetime is important for illumination applications rather than a small viewing angle dependency in emission wavelengths. Thus, for a device with a plurality of organic emitting layers, if a long lifetime can be realized, the long lifetime and the advantages caused by the plurality of organic emitting layers enables a light source having an extremely high luminance and long lifetime.

[Patent document 1] JP-B-3189438
[Patent document 2] JP-A-H11-312584
[Patent document 3] JP-A-H11-312585
[Patent document 4] JP-A-H11-329748
[Patent document 5] JP-A-2003-45676
[Patent document 6] WO2004/095892

In view of the above problems, an object of the invention is to provide an organic EL device with an excellent luminous efficiency and long lifetime.

SUMMARY OF INVENTION

As a result of extensive studies, the inventors found that a longer lifetime as well as an improved luminous efficiency can be realized by using an intermediate conductive layer which is different from an organic emitting layer in refractive index by 0.25 or less and is formed of a material containing an oxide of a rare earth element. The invention has been made on the finding.
According to the invention, the following organic EL device is provided.

1. An organic electroluminescent device comprising:

a transparent electrode;
a counter electrode opposite to the transparent electrode; and
one or more mutilayered structures between the transparent electrode and the counter electrode, the structure comprising two organic emitting layers and an intermediate conductive layer between the organic emitting layers, the refractive index $n_a$ of the intermediate conductive layer being different from the refractive index $n_b$ of at least one of the organic emitting layers by 0.25 or less, the intermediate conductive layer containing an oxide containing one or more types of rare earth elements.

2. The organic electroluminescent device of 1 wherein the intermediate conductive layer is a multilayered body of a layer having a refractive index larger than the refractive index $n_b$ and a layer having a refractive index smaller than the refractive index $n_b$.

3. The organic electroluminescent device of 1 wherein the intermediate conductive layer is formed from a mixture of a material having a refractive index larger than the refractive index $n_b$ and a material having a refractive index smaller than the refractive index $n_b$.

4. The organic electroluminescent device of 2 or 3 wherein the intermediate conductive layer is a multilayered body of a transparent conductive material and a metal halide, or is a mixture film of a transparent conductive material and a metal halide.

5. The organic electroluminescent device of 4 wherein the transparent conductive material comprises an oxide containing at least one element selected from Ce, Nd, Sm and Gd and at least one element selected from In, Zn and Sn.

6. The organic electroluminescent device of any one of 1 to 5 wherein the intermediate conductive layer has an absorption coefficient of 2.5 [1/μm] or less.

According to the invention, an organic EL device with an excellent luminous efficiency and long lifetime can be provided.

Brief Description of Drawings

FIG. 1 is a view showing an embodiment of the organic EL device according to the invention.

FIG. 2. is a partially enlarged view of FIG. 1.

Best Mode for Carrying out the Invention

The organic EL device according to the invention is described below in detail.

FIG. 1 is a view showing an embodiment of the organic EL device according to the invention. The organic EL device is an example where three structures where two organic emitting layers are stacked with an intermediate conductive layer being interposed therebetween are formed.

In the organic EL device 1, a transparent anode (transparent electrode) 12 is provided on a supporting substrate 10 and a cathode (counter electrode) 14, opposed to the anode 12, is provided. Organic emitting layers 20, 22, 24 and 26, and intermediate conductive layers 30, 32 and 34 are provided between the transparent anode 12 and cathode 14 such that one intermediate conductive layer is interposed between two organic emitting layers. Light emitted from the organic emitting layers 20, 22, 24 and 26 appears through the transparent anode 12 from the supporting substrate 10.

FIG. 2 is a partially enlarged view of the intermediate conductive layer 32 interposed between the organic emitting layer 22 and 24 shown in FIG. 1.

The organic emitting layers 22 and 24 are each formed from a hole-injecting layer 200, an emitting layer 202 and electron-injecting layer 204. Holes supplied from the hole-injecting layer 200 are combined with electrons supplied from the electron-injecting layer 204 in the emitting layer 202 to emit light. The surface of the intermediate conductive layer 32 on the organic emitting layer 22 side can inject holes, while the surface of the intermediate conductive layer 32 on the organic emitting layer 24 side can inject electrons.

The refractive index of at least any one of the intermediate conductive layers, for example the intermediate conductive layer 32, is taken as $n_a$ and the refractive index of the organic emitting layers 22 and 24 sandwiching the intermediate conductive layer 32 is taken as $n_b$. In the invention, the difference between the refractive index $n_a$ and refractive index $n_b$ is 0.25 or less. This can suppress the refraction and so on of light emitted from the emitting layer inside the device, thereby enhancing the light outcoupling efficiency (luminous efficiency of the device).

As described later, the intermediate conductive layer uses a transparent conductive material containing an oxide of at least one type of rare earth elements. The addition of the rare-earth-element oxide improves the lifetime of device.

The four organic emitting layers 20, 22, 24 and 26 may be the same or different, and the three intermediate conductive layers 30, 32 and 34 may also be the same or different.

The organic emitting layers 22 and 24, for example, may have different refractive indices. When the refractive indices of the organic emitting layers (first and second organic emitting layers) 22 and 24 are taken as $n_b$ and $n_c$, respectively, one of the following relationships is satisfied in the invention.

$$\text{(i)} \qquad |n_a - n_b| \leq 0.25$$

$$(ii)\quad |n_a - n_c| \leq 0.25$$

$$(iii)\quad |n_a - n_b| \leq 0.25 \text{ and } |n_a - n_c| \leq 0.25$$

Preferably, the relationship (iii) is satisfied, and more preferably the refractive indices of both two organic emitting layers sandwiching an intermediate conductive layer therebetween satisfy the above relationships.

Although the four organic emitting layers are stacked in this embodiment, two, three, or five or more organic emitting layers may be stacked.

Although the transparent electrode is an anode in this embodiment, the transparent electrode may be a cathode.

Each member of the organic EL device is described below.

1. Supporting Substrate

A supporoting substrate is a member for supporting an organic EL device, TFT and the like. The substrate is thus desired to be excellent in mechanical strength and dimension stability. As examples of the substrate, a glass plate, a metal plate, a ceramic plate, a plastic plate (e.g., polycarbonate resin, acrylic resin, vinyl chloride resin, polyethylene terephthalate resin, polyimide resin, polyester resin, epoxy resin, phenol resin, silicon resin, and fluororesin), and the like can be given.

It is preferable that the supporting substrate formed of such a material be subjected to a moisture-proof treatment or hydrophobic treatment by forming an inorganic film or applying a fluororesin in order to prevent water from entering the organic EL display. In particular, the substrate preferably has a small water content and gas transmission coefficient to avoid the invasion of water into an organic luminescent medium. Specifically, it is preferable to adjust the water content of the supporting substrate to 0.0001 wt% or less, and adjust the gas transmission coefficient to $1 \times 10^{-13}$ $cc \cdot cm/cm^2 \cdot sec.cmHg$ or less.

In the above embodiment, the supporting substrate is preferably transparent with a transmittance for visible light of 50% or more since light is outcoupled through the supporting substrate. However if EL emission is outcoupled through the counter electrode, the supporting substrate need not be transparent.

2. Anode (transparent electrode)

As the transparent anode, it is preferable to use metals, alloys, electric conductive compounds and mixtures thereof with a large work function (for example, 4.0 eV or more). Specifically, indium tin oxide (ITO), indium copper, zinc oxide, gold, platinum, palladium, etc. can be used individually or in a combination of two or more.

The thickness of the anode is not particularly limited but preferably ranges from 10 to 1000 nm, more preferably from 10 to 200 nm. The transparent anode is preferably substantially transparent to efficiently outcouple light emitted from an organic emitting layer to the outside. Specifically, it preferably has a light transmittance of 50% or more.

3. Cathode (counter electrode)

As the cathode, it is preferable to use metals, alloys, electric conductive compounds and mixtures thereof with a small work function (for example, less than 4.0 eV). Specifically, magnesium, aluminum, indium, lithium, sodium, cesium, silver, etc. can be used individually or in a combination of two or more.

The thickness of the cathode is not particularly limited but preferably ranges from 10 to 1000 nm, more preferably from 10 to 200 nm.

4. Organic emitting layer

The organic emitting layer can be defined as a medium including an emitting layer which can give EL emission upon the recombination of electrons and holes. The organic emitting layer may be constructed by stacking the following layers on an anode:

a. emitting layer
b. hole-injecting layer/emitting layer
c. emitting layer/electron-injecting layer

d. hole-injecting layer/emitting layer/electron-injecting layer
e. organic semiconductor layer/emitting layer
f. organic semiconductor layer/electron barrier layer/emitting layer
g. hole-injecting layer/emitting layer/adhesion-improving layer

Of these, the configuration d is preferably generally used due to its higher luminance and excellent durability.

As examples of the luminescent material for the emitting layer, a single material or a combination of two or more of a p-quarterphenyl derivative, a p-quinquephenyl derivative, a benzothiazole compound, a benzimidazole compound, a benzoxazole compound, a metal-chelated oxynoid compound, an oxadiazole compound, a styrylbenzene compound, a distyrylpyrazine derivative, a butadiene compound, a naphthalimide compound, a perylene derivative, an aldazine derivative, a pyraziline derivative, a cyclopentadiene derivative, a pyrrolopyrrole derivative, a styrylamine derivative, a coumarin compound, an aromatic dimethylidyne compound, a metal complex having an 8-quinolinol derivative as the ligand, a polyphenyl compound, and the like can be given.

Of these organic luminescent materials, 4,4'-bis(2,2-dit-butylphenylvinyl)biphenyl and 4,4'-bis(2,2-diphenylvinyl)biphenyl (hereinafter abbreviated as DPVBi) and derivatives thereof as the aromatic dimethylidyne compounds are preferable.

A material obtained by doping an organic luminescent material having a distyrylarylene skeleton or the like (host material) with a strong fluorescent dye which emits blue to red light (e.g. coumarin material) or a fluorescent dye similar to the host (dopant) may also be suitably used in combination. Specifically, it is preferable to use DPVBi or the like as a host material and N,N-diphenylaminobenzene or the like as a dopant.

The emitting layer may be formed of a single layer or stacked two or more layers which emit light of the same or different colors.

It is preferable to use a compound having a hole mobility of $1 \times 10^{-6} cm^2/V \cdot sec$ or more measured when applying a voltage of $1 \times 10^4$ to $1 \times 10^6$ V/cm and an ionization energy of 5.5 eV or less for the hole-injecting layer of the organic emitting layer. Holes are reliably injected into the emitting layer by providing such a hole-injecting layer, whereby a high luminance is obtained, or the device can be driven at a low voltage.

As specific examples of the material for the hole-injecting layer, organic compounds such as a porphyrin compound, an aromatic tertiary amine compound, a styrylamine compound, an aromatic dimethylidyne compound, and a condensed aromatic ring compound such as 4,4'-bis[N-(1-naphthyl)-N-phenylamino]biphenyl and 4,4',4"-tris[N-(3-methylphenyl)-N-phenylamino]triphenylamine can be given.

It is also preferable to use an inorganic compound such as p-type Si or p-type SiC as the material for the hole-injecting layer. It is also preferable to provide an organic semiconductor layer with a conductivity of $1 \times 10^{-10}$ S/cm or more between the hole-injecting layer and the anode layer or between the hole-injecting layer and the emitting layer. Holes are more reliably injected into the emitting layer by providing such an organic semiconductor layer.

The thickness of the hole-injecting layer is not particularly limited but preferably ranges from 10 to 300 nm.

It is preferable to use a compound having an electron mobility of $1 \times 10^{-6}$ $cm^2/V \cdot sec$ or more measured when applying a voltage of $1 \times 10^4$ to $1 \times 10^6$ V/cm and an ionization energy of more than 5.5 eV for the electron-injecting layer of the organic emitting layer. Electrons are reliably injected into the emitting layer by providing such an electron-injecting layer, whereby a high luminance is obtained, or the device can be driven at a low voltage. As specific examples of the material for the electron-injecting layer, a metal complex (Al chelate: Alq) of 8-hydroxyquinoline or its derivative or an oxadiazole derivative can be given.

The adhesion-improving layer of the organic emitting-layer may be considered to be one type of electron-injecting layer. Specifically, the adhesion-improving layer is an electron-injecting layer formed of a material exhibiting excellent adhesion to a cathode, and is preferably formed of a metal complex of 8-hydroxyquinoline, its derivative, or the like. It is also preferable to provide an organic semiconductor layer with a conductivity of $1 \times 10^{-10}$ S/cm or more adjacent to the electron-injecting layer. Electrons are more reliably injected into the emitting layer by providing such an organic semiconductor layer.

The thickness of the electron-injecting layer is not particularly limited but preferably ranges from 10 to 300 nm.

The thickness of the organic emitting layer can be preferably in a range of from 5 nm to 5 $\mu$m. If the thickness of the organic emitting layer is less than 5 nm, the luminance and durability may be decreased. If the thickness of the organic emitting layer exceeds 5 $\mu$m, a high voltage must be applied to the device. The thickness of the organic emitting layer is more preferably 10 nm to 3 $\mu$m, and still more preferably 20 nm to 1 $\mu$m.

5. Intermediate conductive layer

Any intermediate conductive layers can be used that have functions of injecting holes through one surface thereof and injecting electrons through the other surface thereof when interposed between adjacent organic emitting layers as shown in FIG. 2.

As the material for forming the intermediate conductive layer, there can be used transparent conductive materials obtained by adding an oxide of a rare earth element to $In_2O_3$, ITO (indium tin oxide), IZO (indium zinc oxide), $SnO_2$, $ZnO_2$, TiN, ZrN, HfN, TiOx, VOx, MoOx, CuI, InN, GaN, $CuAlO_2$, $CuGaO_2$, $SrCu_2O_2$, $LaB_6$, $RuO_2$, etc.

Of these, the transparent conductive materials are preferably an oxide containing one or more rare earth elements selected from Ce, Nd, Sm and Gd, and one or more elements selected from In, Zn and Sn.
The amount of the rare earth element oxide in the transparent conductive materials is determined so as not to impair its conductivity, and specifically is preferably 1 to 30 wt%.

In the invention, in order to improve the light-outcoupling efficiency of the luminescent device, the difference in refractive index between the intermediate conductive layer and the organic emitting layer is 0.25 or less. The intermediate conductive layer is preferably a multilayered body of a layer having a refractive index larger than the refractive index $n_b$ of the organic emitting layer and a layer having a refractive index smaller than the refractive index $n_b$. Alternatively, the intermediate conductive layer is preferably formed from a mixture of a material having a refractive index larger than the refractive index $n_b$ and a material having a refractive index smaller than the refractive index $n_b$.
Specifically a film can be used which is formed of a mixture of a low refractive index material such as metal halides, e.g. metal fluoride represented by LiF and the above transparent conductive material with a higher refractive index than that of the organic emitting layer. A multilayered film of a metal fluoride layer and a transparent conductive material layer may also be used.

The intermediate conductive layer in which a transparent conductive materialis mixes with a low refractive index material such as metal halides can be formed by preparing two deposition sources, filling the sources with the individual materials, and co-depositing the materials. The refractive index can be adjusted by the individual deposition rates. When the low refractive index material is a metal halide such as LiF, as its ratio increases, the condctivity of the intermediate conductive layer is degraded and the material tends not to mix homogeneously. Specifically the ratio of the metal halide in the film is preferably less than 0.6 (weight ratio).

When stacking a film made of a transparent conductive material and a film of a low refractive index material, any multilayer structures are possible which maintain the function of the intermediate conductive layer of injecting carriers, electrons and holes, respectively. Preferred is the three-layer structure of transparent conductive material/low refractive index material/transparent conductive material. The thickness ratio of the low refractive index material layer to the intermediate conductive layer is preferably less than 0.6.

In order to efficiently outcouple light emitted from an organic emitting layer to the outside of a device, an intermediate conductive layer preferably has an absorption coefficient of 2.5 [1/μm] or less, particularly preferably 0.5 [1/μm] or less. In the case where the absorption coefficient is 2.5 [1/μm] or less, assuming that the intermediate conductive layer has a thickness of 30 nm, the transmittance of one intermediate conductive layer is 92%, that of two intermediate conductive layers is 86% and that of three intermediate conductive layers is 80%. Although the transmittance decreases in such a way, it can be kept substantially high. Many transparent conductive materials generally have an extinction coefficient of more than 0.1 but the materials represented by LiF have an extinction coefficient of almost zero. Therefore a mixture or multi-layer structure of the transparent conductive material and low refractive index material allows the absorption coefficient to be reduced, thereby improving the luminous efficiency of the device.

When a device has a plurality of intermediate conductive layers, all intermediate conductive layers preferably have an absorption coefficient of 2.5 [1/μm] or less.
As an example of methods for making the absorption coefficient of an intermediate conductive layer 2.5 [1/μm] or less, when forming the intermediate conductive layer by sputtering, an oxygen partial pressure [oxygen/(oxygen + argon)] during sputtering is adjusted.

When an organic emitting layer and/or intermediate conductive layer are/is a multilayered film, the refractive index of the organic emitting layer and intermediate conductive layer is defined to be an equivalent refractive index.
For example, with respect to an intermediate conductive layer formed by stacking high and low refractive index films, the definition of its refractive index for light of a wavelength λ will be described. The thickness and refractive index of the high refractive index material are taken as $d_1$ and $n_1$, respectively. The thickness and refractive index of the low refractive index material are taken as $d_2$ and $n_2$, respectively. Further, $\delta_1$ and $\delta_2$ are defined as expression (1).

$$\delta_1 = 2\pi n_1 d_1 / \lambda$$
$$\delta_2 = 2\pi n_2 d_2 / \lambda \qquad (1)$$

Two × two matrix M is defined as expression (2).

$$\mathbf{M} = \begin{pmatrix} m_{11} & m_{12} \\ m_{21} & m_{22} \end{pmatrix} = \begin{pmatrix} \cos\delta_1 & i\cdot\frac{\sin\delta_1}{n_1} \\ i\cdot n_1\cdot\sin\delta_1 & \cos\delta_1 \end{pmatrix}\begin{pmatrix} \cos\delta_2 & i\cdot\frac{\sin\delta_2}{n_2} \\ i\cdot n_2\cdot\sin\delta_2 & \cos\delta_2 \end{pmatrix}\begin{pmatrix} \cos\delta_1 & i\cdot\frac{\sin\delta_1}{n_1} \\ i\cdot n_1\cdot\sin\delta_1 & \cos\delta_1 \end{pmatrix} \quad (2)$$

Here, the equivalent refractive index N of the multilayered film is defined as expression (3).

$$N = \sqrt{\frac{m_{21}}{m_{12}}} \quad (3)$$

The refractive index of the entire organic emitting layer can similarly be defined based on the above expressions (1) to (3) using the refractive indices of a hole-injecting material, a luminescent material, an electron-injecting material, etc. constituting the organic emitting layer. Many materials constituting the organic emitting layer have a refractive index of about 1.7 to about 1.8. As a result, the equivalent refractive index of the organic emitting layer usually has a refractive index of about 1.7 to about 1.8. Thus an intermediate conductive layer with a refractive index of 1.5 to 2.0 is preferred. In view of an absorption coefficient of 2.5 [1/$\mu$m] or less, the intermediate conductive layer preferably has an extinction coefficient of 0.1 or less.

EXAMPLES

The invention will be described more specifically referring to Examples.

Example 1

(1) Preparation of glass substrate with ITO

A supporting substrate measuring 25 mm $\times$ 75 mm (OA2 glass, Nippon Electric Glass Co., Ltd) was subjected to ultrasonic cleaning in pure water and isopropyl alcohol, drying with air blowing and then UV cleaning. Next, the resultant substrate was moved to a sputtering apparatus and an ITO film was formed in a thickness of 150 nm.

(2) Formation of organic emitting layer

Next, the substrate was moved to an organic deposition apparatus and fixed in a substrate holder. After a vacuum vessel was evacuated to $5 \times 10^{-7}$ torr, a hole-injecting layer, emitting layer and electron-injecting layer were sequentially formed.
First, as a hole-injecting layer, 4,4',4"-tris[N-(3-methylphenyl)-N-phenylamine (MTDATA) was deposited in a thickness of 55 nm.
Next, as an emitting layer, 4,4'-bis(2,2-diphenylvinyl)biphenyl (DPVBi) as a host and 1,4-bis[4-(N,N-diphenylaminostyrylbenzene)] (DPAVB) as a dopant were codeposited at depositing rates of 0.1 to 0.3 nm/second and 0.003 to 0.008 nm/second, respectively to form a 40-nm-thick film.
Next, as an electron-injecting layer, tris(8-quinolinol)aluminum (Alq) was deposited in a thickness of 20 nm.

(3) Formation of intermediate conductive layer

A mixture of ITO and a cerium oxide ($In_2O_3$:$SnO_2$:$CeO_2$ = 90:5:5 (weight ratio, the ratios stated hereinafter are also expressed by weight) (the mixture is abbreviated as ITCO hereinafter) was prepared as a sputtering source. Lithium fluoride (LiF) was prepared as a depositing source independently from the sputtering source. A 10-nm-thick ITCO film,

10-nm-thick LiF film and 10-nm-thick ITCO film were sequentially formed.

(4) Formation of organic emitting layer, intermediate conductive layer, organic emitting layer and cathode

An organic emitting layer, intermediate conductive layer and organic emitting layer were formed on the intermediate conductive layer formed in the above (3) in a similar way to the above (1) and (2).
Next, an aluminum film was formed in a thickness of 150 nm as a cathode, thereby fabricating an organic EL device containing three organic emitting layers and two intermediate conductive layers.

(5) Measurement of refractive indices of organic emitting layer and intermediate conductive layer

The hole-injecting layer, emitting layer and electron-injecting layer were individually formed on a glass substrate (OA2 glass, Nippon Electric Glass Co., Ltd.) in a thickness of 0.2 μm by the same method as the above (2). The films were measured for refractive index to 500 nm wavelength light with an ellipsometer. The equivalent refractive index of the organic emitting layer was determined using the film thickness values shown in the above (2). The equivalent refractive index obtained was 1.79.
An ITCO film and a lithium fluoride film were individually formed on a glass substrate by the above (3) method. The films were measured for refractive index to 500 nm wavelength light with the ellipsometer. The refractive index of ITCO film was 2.1 and the refractive index of lithium fluoride film was 1.4.
The equivalent refractive index of the intermediate conductive layer was determined using the film thickness values shown in the above (3). The equivalent refractive index obtained was 1.85.
The difference in equivalent refractive index between the organic emitting layer and intermediate conductive layer was 0.06.
The intermediate conductive layer was measured for absorption coefficient with an absorption spectrometer. The absorption coefficient was 2.13 [1/μm].

(6) Measurement of emission performance of organic EL device

Upon applying current across the ITO and aluminum cathode at a current density of 1.4 $mA/cm^2$, the organic EL device emitted blue light. The device was measured for luminance from the front thereof with a spectroradiometer (CS1000, MINOLTA Co., Ltd.). The luminance was 387 $cd/m^2$.
Next, the device was caused to emit light at 2000 $cd/m^2$ and the time (half life) taken until the luminance decreased by half to 1000 $cd/m^2$ was measured. The half life was 2400 hours.

Example 2

An organic EL device was fabricated and evaluated by the same method as in Example 1 except that the intermediate conductive layer was formed by co-depositing a mixture of $In_2O_3$ and cerium oxide ($In_2O_3$:$CeO_2$ = 95:5, refractive index; 2.2), and LiF (film thickness; 30 nm, $In_2O_3$/$CeO_2$ mixture:LiF = 8:2, weight ratio).
As a result, the refractive index and absorption coefficient of the intermediate conductive layer were 1.95 and 2.12 [1/μm], respectively. The difference in equivalent refractive index between the organic emitting layer and intermediate conductive layer was 0.16.
The front-direction luminance and half time of the organic EL device were 355 nit and 2250 hours, respectively.

Example 3

An organic EL device was fabricated and evaluated by the same method as in Example 1 except that the intermediate conductive layer was a single layer of IZO and cerium oxide ($In_2O_3$:ZnO:$CeO_2$ = 85:10:5, film thickness: 30 nm).
As a result, the refractive index and absorption coefficient of the intermediate conductive layer were 2.04 and 2.58 [1/μm], respectively. The difference in equivalent refractive index between the organic emitting layer and intermediate conductive layer was 0.25.
The front-direction luminance and half time of the organic EL device were 280 nit and 1800 hours, respectively.

Example 4

An organic EL device was fabricated and evaluated by the same method as in Example 3 except that the emitting layer was of multilayer type of a blue emitting layer and an orange emitting layer described below.

The orange emitting layer was firstly stacked on the hole-injecting layer, and thereafter the blue emitting layer was stacked. The orange emitting layer was formed in a thickness of 5 nm from the materials of formulas (1) and (2) ((1):(2) = 5:0.01 by weight).
The blue luminescent medium was formed in a thickness of 35 nm from the materials of formulas (1) and (3) ((1): (3) = 35:0.8 by weight).

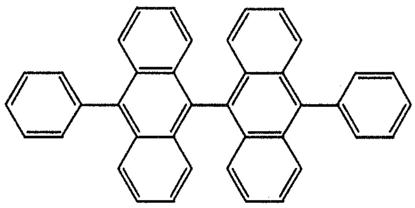

(1)

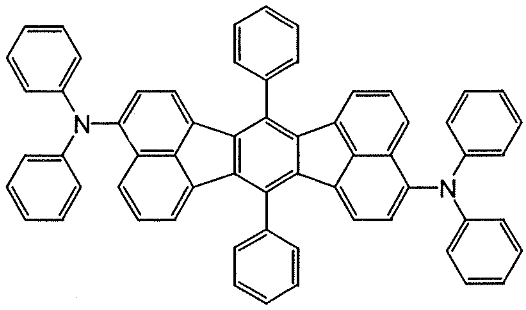

(2)

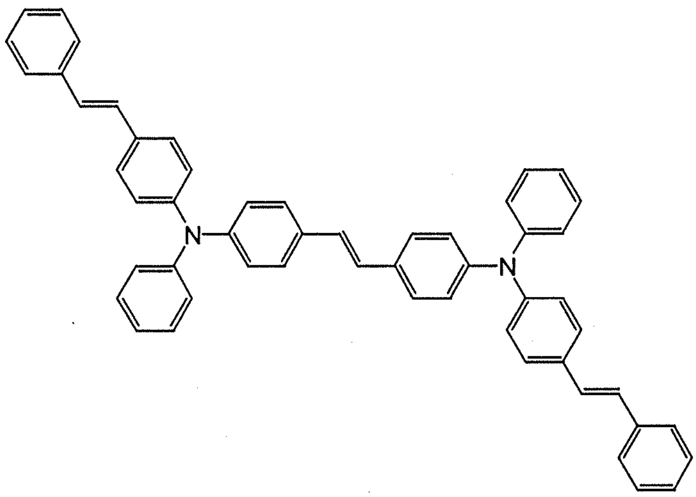

(3)

In this organic EL device, the organic emitting layer had a refractive index of 1.79 like the other examples. The refractive index and absorption coefficient of the intermediate conductive layer were 1.95 and 2.52 [1/μm], respectively. The difference in equivalent refractive index between the organic emitting layer and intermediate conductive layer was 0.16.
The front-direction luminance and half time of the organic EL device were 338 nit and 2900 hours, respectively.

Comparative Example 1

An organic EL device was fabricated and evaluated by the same method as in Example 1 except that the

intermediate conductive layer was a single layer of $V_2O_5$ (film thickness; 30 nm).
As a result, the refractive index and absorption coefficient of the intermediate conductive layer were 2.20 and 3.02 [1/μm], respectively. The difference in equivalent refractive index between the organic emitting layer and intermediate conductive layer was 0.41.
The front-direction luminance and half time of the organic EL device were 320 nit and 1200 hours, respectively.

Comparative Example 2

An organic EL device was fabricated and evaluated by the same method as in Example 1 except that ITCO used for forming the intermediate conductive layer was changed to ITO ($In_2O_3$:$SnO_2$ = 90:10 by weight).
As a result, the refractive index and absorption coefficient of the intermediate conductive layer were 1.90 and 1.95 [1/μm], respectively. The difference in equivalent refractive index between the organic emitting layer and intermediate conductive layer was 0.16.
The front-direction luminance and half time of the organic EL device were 160 nit and 800 hours, respectively.

INDUSTRIAL APPLICABILITY

The organic EL device of the invention can be used in combination of known structures suitably for various displays such as consumer televisions, large displays and displays for portable telephones, and light sources of various illuminations.

## Claims

1. An organic electroluminescent device comprising:

   a transparent electrode;
   a counter electrode opposite to the transparent electrode; and
   one or more mutilayered structures between the transparent electrode and the counter electrode, the structure comprising two organic emitting layers and an intermediate conductive layer between the organic emitting layers, the refractive index $n_a$ of the intermediate conductive layer being different from the refractive index $n_b$ of at least one of the organic emitting layers by 0.25 or less, the intermediate conductive layer containing an oxide containing one or more types of rare earth elements.

2. The organic electroluminescent device of claim 1 wherein the intermediate conductive layer is a multilayered body of a layer having a refractive index larger than the refractive index $n_b$ and a layer having a refractive index smaller than the refractive index $n_b$.

3. The organic electroluminescent device of claim 1 wherein the intermediate conductive layer is formed from a mixture of a material having a refractive index larger than the refractive index $n_b$ and a material having a refractive index smaller than the refractive index $n_b$.

4. The organic electroluminescent device of claim 2 or 3 wherein the intermediate conductive layer is a multilayered body of a transparent conductive material and a metal halide, or is a mixture film of a transparent conductive material and a metal halide.

5. The organic electroluminescent device of claim 4 wherein the transparent conductive material comprises an oxide containing at least one element selected from Ce, Nd, Sm and Gd and at least one element selected from In, Zn and Sn.

6. The organic electroluminescent device of any one of claims 1 to 5 wherein the intermediate conductive layer has an absorption coefficient of 2.5 [1/μm] or less.

FIG. 1

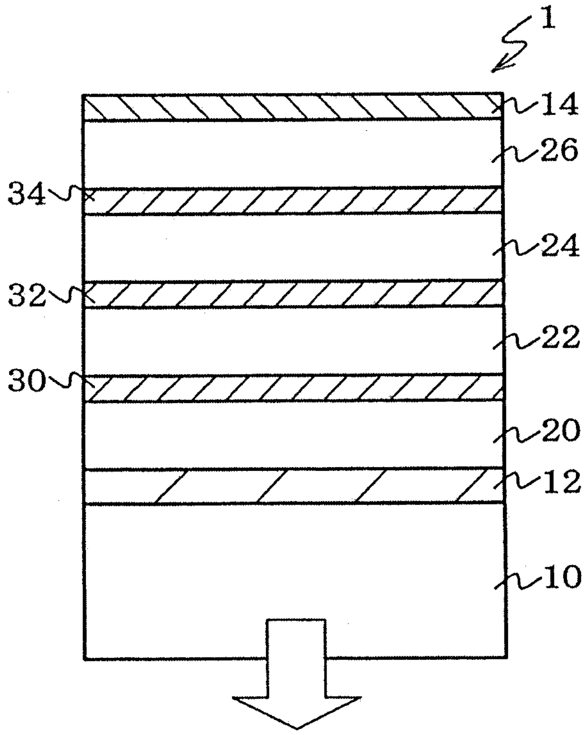


FIG. 2

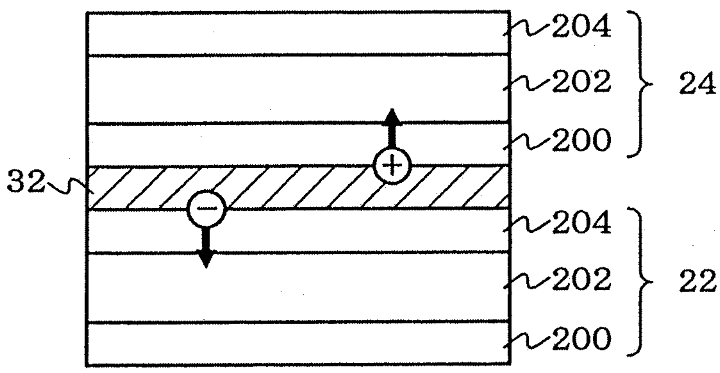

**INTERNATIONAL SEARCH REPORT**

International application No.
PCT/JP2006/309266

A. CLASSIFICATION OF SUBJECT MATTER
*H05B33/12*(2006.01), *H01L51/50*(2006.01), *H05B33/26*(2006.01), *H05B33/28* (2006.01)

According to International Patent Classification (IPC) or to both national classification and IPC

B. FIELDS SEARCHED

Minimum documentation searched (classification system followed by classification symbols)
*H05B33/12*(2006.01), *H01L51/50*(2006.01), *H05B33/26*(2006.01), *H05B33/28* (2006.01)

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2004/095892 A1 (Idemitsu Kosan Co., Ltd.), 04 November, 2004 (04.11.04), Claims 1 to 7; page 9, lines 11 to 23 (Family: none) | 1-6 |
| Y<br>A | JP 2004-119272 A (Idemitsu Kosan Co., Ltd.), 15 April, 2004 (15.04.04), Claims 1 to 2; Par. Nos. [0022] to [0023], [0045] & US 2004/0081836 A1 & EP 001536034 A1 & WO 2004/013372 A1 & CN 001675399 A | 1<br>2-6 |
| Y<br>A | JP 2004-146136 A (Idemitsu Kosan Co., Ltd.), 20 May, 2004 (20.05.04), Claims 1 to 4; Par. No. [0013] & US 2004/0081836 A1 & EP 001536034 A1 & WO 2004/013372 A1 & CN 001675399 A | 1<br>2-6 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>06 July, 2006 (06.07.06) | Date of mailing of the international search report<br>18 July, 2006 (18.07.06) |
| Name and mailing address of the ISA/<br>Japanese Patent Office<br>Facsimile No. | Authorized officer<br><br>Telephone No. |

Form PCT/ISA/210 (second sheet) (April 2005)

**INTERNATIONAL SEARCH REPORT**

International application No. PCT/JP2006/309266

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2004-252406 A (Seiko Epson Corp.),<br>09 September, 2004 (09.09.04),<br>Par. No. [0045]<br>& JP 2004-281365 A & JP 2005-235790 A<br>& US 2004/0178725 A1 & US 2004/0178724 A1 | 1<br>2-6 |
| Y<br>A | JP 11-329748 A (Idemitsu Kosan Co., Ltd.),<br>30 November, 1999 (30.11.99),<br>Full text<br>& US 006107734 A1 | 1<br>2-6 |
| A | Supervised by Yoshiharu SATO, "Yuki EL Zairyo Gijutsu", Kabushiki Kaisha CMC Shuppan, 31 May, 2004 (31.05.04), pages 29 to 31 | 1-6 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 3189438 B
- JP H11312584 A
- JP H11312585 A
- JP H11329748 A
- JP 2003045676 A
- WO 2004095892 A